# EUROPEAN PATENT SPECIFICATION

(11) **EP 0 740 336 B1**
(45) Date of publication and mention of the grant of the patent: **07.08.2002**
(21) Application number: 96106658.6
(22) Date of filing: 26.04.1996
(51) Int. Cl.: H01L 21/74, H01L 21/768

(54) **Method for fabricating semiconductor device having buried contact structure**
Verfahren zum Herstellen einer Halbleiteranordnung mit vergrabener Kontaktstruktur
Méthode de fabrication d'un dispositif semi-conducteur comportant une structure de contact inséré

(30) Priority: 27.04.1995 JP 12567795
(43) Date of publication of application: 30.10.1996
(73) Proprietor: NEC CORPORATION, Tokyo (JP)
(72) Inventor: Yamamori, Atsushi, Tokyo (JP)
(74) Representative: Glawe, Delfs, Moll & Partner

(56) References cited:
- EP-A- 0 452 921
- EP-A- 0 506 129
- EP-A- 0 596 364
- JP-A- 6 140 372
- US-A- 5 081 043
- BROADBENT E K: "NUCLEATION AND GROWTH OF CHEMICALLY VAPOR DEPOSITED TUNGSTEN ON VARIOUS SUBSTRATE MATERIALS: A REVIEW" JOURNAL OF VACUUM SCIENCE AND TECHNOLOGY: PART B, vol. 5, no. 6 + INDEX, November 1987, pages 1661-1666, XP000008344
- PATENT ABSTRACTS OF JAPAN vol. 018, no. 171 (E-1529), 23 March 1994 -& JP 05 343531 A (SEIKO EPSON CORP), 24 December 1993,

## Description

### Background of the Invention

The present invention relates to a method of producing a semiconductor device having the so-called buried contact structure and, more particularly, to an improvement in a method for forming such a buried contact structure that employs a tungsten (W) plug.

In a semiconductor device, an electrical connection between lower-level and upper-level wiring layers or between a wiring layer and a semiconductor region is performed by providing a contact-hole or a via-hole in an interlayer insulating film intervening therebetween. As such devices increase in integration density, the contact or via-holes are formed with increasing by smaller size and in deeper depth. That is, each hole has a large aspect ratio.

On the other hand, a wiring layer is generally made of aluminum or an alloy consisting of aluminum and other metals such as silicon and copper by a sputtering method. However, the aluminum layer deposited by the sputtering method cannot completely fill a hole having a large aspect ratio. Therefore, it is proposed that the hole provided in the interlayer insulating film is filled with a refractory metal plug such as tungsten. Such a structure is called buried contact structure.

The hole with the tungsten plug is formed as follows: First, a silicon substrate having a diffusion region or a polysilicon layer serving as a lower-level wiring layer is covered with a silicon oxide film as an interlayer insulating film, and the silicon oxide film is selectively removed to form a contact-hole exposing a part of the diffusion region or a via-hole exposing a part of the lower-level wiring layer. Thereafter, a titanium (Ti) layer and a titanium nitride (TiN) layer are deposited in that order on the entire surface of the substrate, followed by forming a blanket tungsten layer by the CVD method using WF₆H₂ on the entire surface of the substrate. The blanket tungsten layer is then etched back by using SF₆ until the surface of the TiN layer is exposed. The tungsten plug filling the hole is thus formed. Subsequently, an aluminum or aluminum alloy is deposited over the entire layer and then patterned to form an aluminum wiring layer.

The method of the above-mentioned, however, fluorine is adhered on the TiN layer when the blanket tungsten layer is etched back by using SF₆ and thereafter, grains of titanium fluoride combined from titanium and fluorine are formed on the TiN layer when the wafer is exposed to the atmosphere for a long time.

It has now been found that when a wafer is exposed to the atmosphere, moisture in the atmosphere reacts on fluorine to form hydrogen fluoride (HF), and the surface of the titanium nitride film is fluorinated by the hydrogen fluoride, and grains of titanium fluoride are formed. Moreover, an aluminum alloy film for forming wires is not smoothly etched due to the grains of titanium fluoride or a short circuit is formed between wires. The adhesiveness of an aluminum alloy is impaired which deteriorates the yield and reliability of the semiconductor devices.

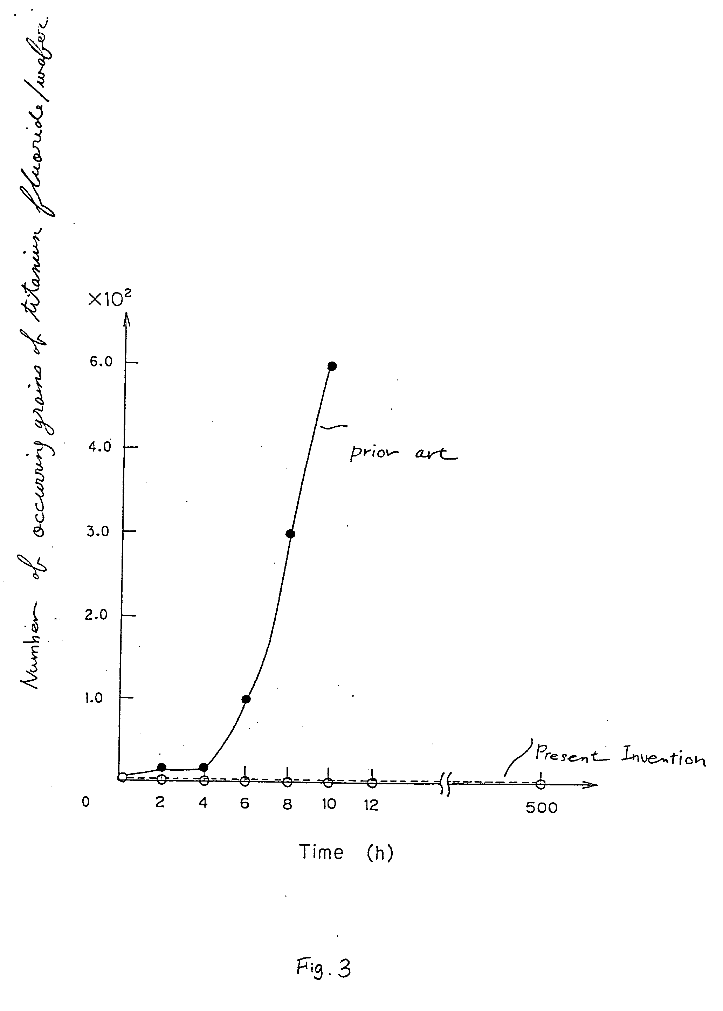

The inventor studied relationship between the number of occurring grains of titanium fluoride and the time of exposure of the wafer to the atmosphere after the blanket tungsten layer is etched back by using SF₆. Fig. 3 indicates the result of its study. The X axis represents the time for leaving the wafer in the atmosphere after the blanket tungsten layer is etched back by using SF₆ and the Y axis represents the number of occurring grains of titanium fluoride.

Referring to Fig. 3, the number of grains of titanium fluoride increases very little within 4 hours in the atmosphere after the blanket tungsten layer is etched back by using SF₆ but rapidly increases after 4 hours. That is, most of the Fluorine only adheres on the titanium nitride within the first 4 hours.

Two methods of removing fluorine from the TiN layer and two methods for removing grains of titanium fluoride are disclosed in Japanese Laid-open Patent Application No. Hei 6-140372.

The first method of removing grains of titanium fluoride on the TiN layer is by soaking the titanium nitride film in an alkali solution such as ammonia to slightly etch the surface of the film. The second method of removing grains of titanium is by sputtering etching using an argon gas.

However, each of the two methods etches the entire surface on the substrate. Since the tungsten plug also is etched, the resistance between the lower-level layer and the upper-level layer increases. It is difficult to remove titanium fluoride itself.

Accordingly, it is better to remove the fluorine before fluorine reacts with titanium.

A first method, disclosed in EP-A-0 596 364, for removing fluorine from the TiN layer is by picking out the wafer having remaining fluorine on the TiN layer from the CVD chamber and heating the wafer in an inert gas before the fluorine reacts with titanium in the TiN layer. A second method removing fluorine is by soaking the wafer in pure water to wash out fluorine before it reacts with titanium.

However, in fact, a plurality of processes are carried out in series to complete semiconductor products. Therefore, the apparatus to remove fluorine is often used to produce other semiconductor products when the step of etching back the blanket tungsten by using SF₆ is finished. Also, the etching apparatus has to be used for other semiconductor products. The apparatus for etching the surface on the substrate and the apparatus used to remove fluorine are different. Accordingly, the wafer after finishing the etching of the blanket tungsten by using SF₆ is picked out of the etching aparatus and is left in the atmosphere. However, the etching apparatus is usually used continuously more than 4 hours. Therefore it is often not possible in practice to carry out the first or second method for removing fluorine within 4 hours after the blanket tungsten is etched back by using SF₆.

EP-A-0 452 921 dicloses formation of titanium nitride on a semiconductor wafer using an apparatus having a vacuum chamber coupled to an etching chamber for cleaning, a PVD chamber for depositing Ti and an annealing chamber for reacting Ti will a nitrogen atmosphere to form TiN.

### Summary of the Invention

It is an object of the present invention to provide a method for completely removing fluorine from the surface of a titanium nitride film even if a wafer is left for a long time after etching the whole surface of a blanket tungsten layer. It is another object of the present invention to provide a method for surely removing fluorine on a titanium nitride film even after 4 hours after etching the whole surface of a blanket tungsten layer. It is still another object of the present invention to provide a method for improving the fabrication yield and reliability of semiconductor devices.

A method of fabricating semiconductor device of the present invention comprises the steps as defined in claim 1.

### Brief Description of the Drawings

The above and other objects, advantages, and features of the present invention will be more apparent from the following description taken in conjunction with the accompanying drawings, in which:
Figs. 1A to 1E are cross sectional views illustrative of respective steps of producing a semiconductor device according to a embodiment of the present invention;

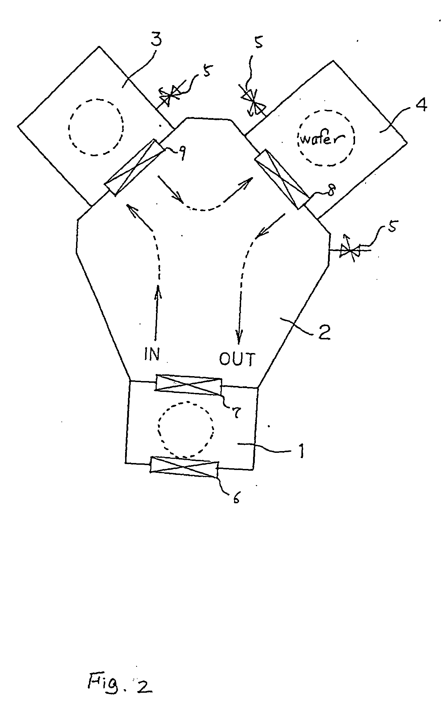

Fig. 2 is a schematic diagram of a semiconductor device fabrication system employed in the method shown in Fig. 1 for explaining an embodiment of the present invention; and
Fig. 3 is a graph for explaining the advantages of the present invention and disadvantages of the prior art.

### Detailed description of the Preferred Embodiments

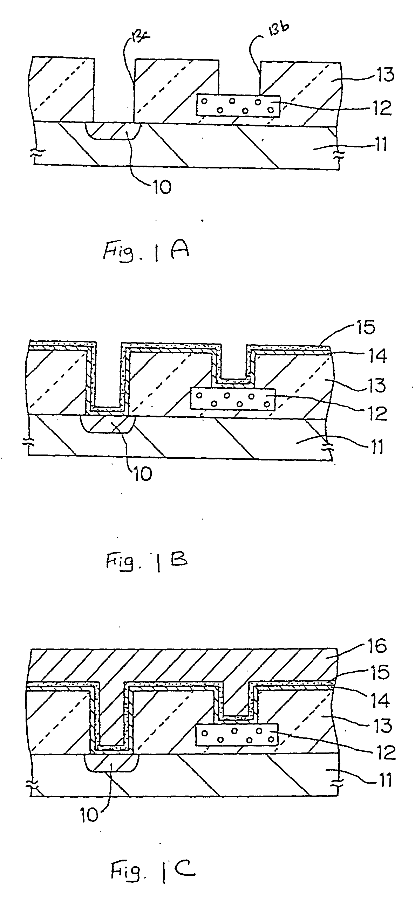

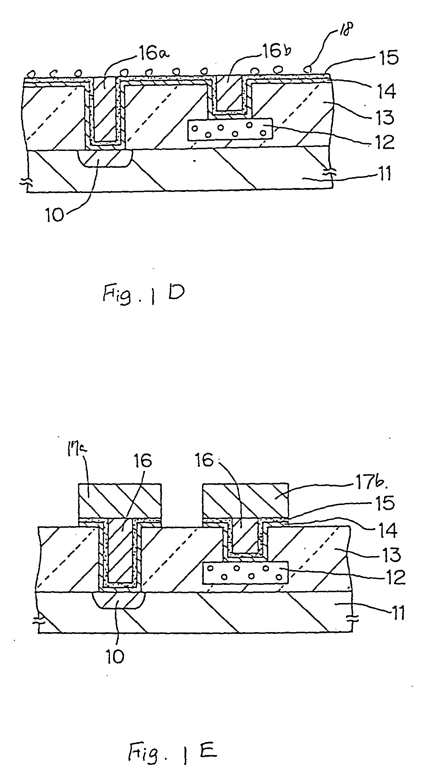

Referring to Fig. 1, a description will be made of a first embodiment of the present invention.

First, as shown in Fig. 1A, a silicon oxide film 13 is formed on a silicon substrate 11 with a diffusion layer 10. A polysilicon layer 12 serving as a lower-level wiring layer is formed and pattern-etched. The surface of the layer 12 is further covered with a silicon oxide film 13. Thereafter, a contact-hole 13a reaching the diffusion layer 10 and a via-hole 13b reaching the polysilicon layer 12 is formed at a desired position of the silicon oxide film 12 by a selective etching process.

Then, as shown in Fig. 1B, a titanium film 14 and a titanium nitride film 15 are formed in that order by sputtering up to a thickness of 10 to 100 nm and a thickness of 50 to 200 nm respectively. The titanium film 14 is necessary to decrease contact resistances with the silicon substrate 11 and the polysilicon layer 12. Moreover, it is preferable that the titanium film 14 has a thickness of 10 nm or more at the bottom of the contact-hole 13a or the via-hole 13b and the film thickness is determined by the depth and diameter of the contact-hole 13a or the via-hole 13a. Furthermore, the titanium nitride film 15 is necessary to prevent that the substrate or the polysilicon layer and the WF₆ serving as a source gas for depositing tungsten react with each other.

Then, as shown in Fig. 1C, a blanket tungsten layer 16 is formed up to a thickness of 0.5 to 1.0 µm by low-pressure chemical vapor deposition. To completely flatten a contact-hole 13a or a via-hole 13b, it is necessary to form the film 16 up to a thickness approximately equal to or more than the width (diameter) of the contact-hole 13a or the via-hole 13b. Moreover, the blanket tungsten layer 16 is mainly formed by a method of reducing WF₆ by hydrogen having a preferable covering property. Before forming the layer 16, however, it is preferable to deposit a thin tungsten film by reducing WF₆ by SiH₄ in order to stably form the blanket tungsten layer 16. Deposition of the blanket tungsten layer 16 is performed at a temperature of 400 to 500°C and a pressure of several hundreds of mTorr.

Then, a post-treatment method for etching back the whole surface of the blanket tungsten layer 16 is performed as described below by referring to the semiconductor device fabrication system shown in Fig. 3. The system has 4 chambers. Each of the chambers has a vacuum pump (not shown). A load-lock chamber 1 has a gate valve 6 connected to outside of the system. An etching chamber 3 has a gas valve 5 for gas such as an etching gas. A post-treatment chamber 4 has a gas valve 5 for gas such as nitrogen gas. A vacuum chamber 2 has gate valves 7, 8, 9 connected to the chamber 1, 4, 3 respectively. The vacuum chamber 2 transfers a wafer among the chambers 1, 3, 5 while keeping a vacuum atmosphere.

First, a wafer having the blanket tungsten layer 16 formed on the substrate is set into the load-lock chamber 1. Then, the wafer is set into the etching chamber 3 through the vacuum chamber 2.

Then, as shown in Fig. 1D, the whole surface of the blanket tungsten layer 16 is dry-etched in SF₆ gas to expose the surface of the titanium nitride film 15 at the flat portion and leave the tungsten only in the via-hole 13b or the contact-hole 13a. Tungsten plugs 16a,b filling the hole 13a, 13b respectively are thus formed. At this time fluorine 18 is adhered on the titanium nitride film 15.

After the whole surface of the blanket tungsten layer on the wafer is etched back in the etching chamber 3, the wafer is transferred to the post-treatment chamber 4 through the vacuum chamber 2. At this time, the wafer may be left in the vacuum chamber 2 for a long time, for example, more than 4 hours.

The fluorine 18 on the surface of the titanium nitride film 16 is dissociated and removed by setting the treatment pressure in the post-treatment chamber 4 to 0.3 Torr or lower, raising the wafer temperature to 220°C or higher, and blowing nitrogen on the wafer surface for 20 sec or more. The fluorine also can be dissociated and removed by setting the treatment pressure in the vacuum chamber to 0.3 Torr or lower in the nitrogen gas and raising the wafer temperature 220°C or higher. It is not clear why fluorine can be removed by the method. However, the inventor thinks that fluorine can be removed by chemical action.

Figure 3 shows by the broken line the relation between the time of leaving the wafer in vacuum after the above treatment is applied to the wafer and the occurring number of grains of titanium fluoride of the present invention. As the result, titanium fluoride do not occur at all even if a wafer is left in vacuum for a long time.

It is possible to use not only nitrogen but also an inert gas such as helium, neon, or argon for the above treatment.

Referring to Fig. 1E, an aluminum alloy film is deposited by sputtering. Thereafter, the aluminum alloy film, titanium nitride film 15, and titanium film 14 are formed into desired shapes and patterned to form an aluminum wiring layer 17a, 17b by photolithography and dry etching. Thus, a semiconductor device having a buried contact structure is produced.

The steps of etching back the blanket tungsten layer and removing fluorine of the present invention are carried out in respective chambers. This prevents fluorine which remains on the inner wall of etching chamber 3 when the blanket tungsten layer is etched back by using SF₆ from attaching onto the titanium nitride film again, as would happen if fluorine were removed in the etching chamber.

A method of removing fluorine from the surface of the titanium nitride film according to a second embodiment of the present invention is described below. The method from FIG. 1A to 1D is the same method. Then, the wafer is exposed to hydrogen-gas plasma in the post-treatment chamber 4.

Fluorine adheres to the surface of a titanium nitride film on the wafer transferred to the post-treatment chamber 4 and the intermolecular binding energy between titanium and fluorine is 136 kcal/mol. However, the intermolecular binding energy between fluorine and hydrogen is 153 kcal/mol. Therefore, it is possible to separate or disassociate the bound titanium and fluorine from each other by plasma and remove the fluorine by chemical reaction of hydrogen-gas plasma without applying thermal treatment.

As described above, the semiconductor device fabrication method of the present invention dry-etches a tungsten film on a titanium nitride film by a gas containing fluorine, then transfers the etched film to a post-treatment chamber from the etching chamber without exposing it to the atmosphere, and removing fluorine from the titanium nitride film in the post-treatment chamber. Therefore, it is possible to completely remove fluorine from the surface of the titanium nitride film and prevent grains of titanium fluoride fom occurring on the surface of the titanium nitride film. Thus, the present invention makes it possible to form an aluminum wiring having a via-hole covered with a tungsten film having a high adhesiveness without causing a short circuit between wires and improve the yield and reliability of semiconductor devices.

## Claims

1. A method of fabricating a semiconductor device comprising:
forming over a semiconductor substrate (11) a conductive layer (14, 15) including titanium;
forming a tungsten film (16) on said conductive layer;
etching back said tungsten film by using a reactive gas containing fluorine until the surface of said conductive layer is exposed;
removing fluorine from the surface of said conductive layer;
**characterized in that**
said semiconductor substrate (11) is kept in a vacuum atmosphere for the period of time from finishing the step of etching back until starting the step of removing fluorine and that said fluorine is removed by heating said semiconductor substrate while blowing an inert gas on the surface of said semiconductor substrate.

2. The method as claimed in claim 1, wherein said semiconductor substrate is heated to a temperature of 220°C or higher.

3. The method as claimed in claim 1, wherein said step of removing fluorine is performed in a hydrogen plasma gas.

4. The method as claimed in claim 2 or 3, further comprising:
forming an insulating film (13) on said semiconductor substrate before said conductive layer (14, 15) is formed; and
selectively forming a hole (13a, 13b) in said insulating film to expose a part of said semiconductor substrate;
wherein said conductive film (14, 15) is formed so as to be in contact with said insulating film (13) and said part of said semiconductor substrate (11).

5. The method as claimed in any of claims 1 to 4, wherein said method is carried out in an apparatus which has a first chamber (3), a second chamber (4) and a vacuum chamber (2) coupled to said first and second chambers;
said tungsten film (16) is etched back in said first chamber (3);
said semiconductor substrate is transferred from said first chamber (3) into the vacuum chamber (2) while keeping a vacuum after said tungsten film is etched back;
said semiconductor substrate is kept in a vacuum atmosphere in said vacuum chamber (2) for a period of time;
said semiconductor substrate is transferred from said vacuum chamber (2) into said second chamber (4) while keeping a vacuum; and
said fluorine is removed in said second chamber (4).

6. The method as claimed in claim 4, wherein said conductive film comprises a titanium film (14) formed on said insulating film (13) and said part of said semiconductor substrate (11) and a titanium nitride (15) film formed on said titanium film.

7. A method as claimed in claim 1 or 5, wherein said period of time is more than 4 hours.

## Patentansprüche

1. Verfahren zum Herstellen einer Halbleitervorrichtung mit:
Ausbilden einer leitfähigen Schicht (14, 15), die Titan enthält, über einem Halbleitersubstrat (11);
Ausbilden eines Wolframfilms (16) auf der leitfähigen Schicht;
Zurückätzen des Wolframfilms unter Verwendung eines reaktiven Gases, welches Fluor enthält, bis die Oberfläche der leitfähigen Schicht freigelegt ist;
Entfernen des Fluors von der Oberfläche der leitfähigen Schicht;
**dadurch gekennzeichnet, daß**
das Halbleitersubstrat (11) für die Zeitperiode vom Beenden des Schrittes Zurückätzen bis zum Beginn des Schrittes Entfernen des Fluors in einer Unterdruckatmosphäre gehalten wird, und daß das Fluor durch Erhitzen des Halbleitersubstrates unter Blasen eines Inertgases auf die Oberfläche des Halbleitersubstrats entfernt wird.

2. Verfahren nach Anspruch 1,
wobei das Halbleitersubstrat auf eine Temperatur von 220°C oder höher erhitzt wird.

3. Verfahren nach Anspruch 1,
wobei der Schritt Entfernen des Fluors in einem Wasserstoffplasmagas durchgeführt wird.

4. Verfahren nach Anspruch 2 oder 3,
weiterhin mit:
Ausbilden eines Isolierfilms (13) auf dem Halbleitersubstrat vor dem Ausbilden der leitfähigen Schicht (14, 15); und
selektivem Ausbilden eines Loches (13a, 13b) in dem Isolierfilm, um einen Teil eines Halbleitersubstrats freizulegen;
wobei der leitfähige Film (14, 15) so ausgebildet ist, daß er mit dem Isolierfilm (13) und dem Teil des Halbleitersubstrats (11) in Kontakt ist.

5. Verfahren nach einem der Ansprüche 1 bis 4,
wobei das Verfahren in einem Apparat ausgeführt wird, der eine erste Kammer (3), eine zweite Kammer (4) und eine Unterdruckkammer (2) hat, die an die ersten und zweiten Kammern gekoppelt ist;
der Wolframfilm (16) in der ersten Kammer (3) zurückgeätzt wird;
das Halbleitersubstrat von der ersten Kammer (3) in die Unterdruckkammer (2) transferiert wird, wobei ein Unterdruck nach dem Zurückätzen des Wolframfilms aufrechterhalten wird;
das Halbleitersubstrat in der Unterdruckkammer (2) für eine Zeitperiode in einer Unterdruckatmosphäre gehalten wird;
das Halbleitersubstrat von der Unterdruckkammer (2) in die zweite Kammer (4) transferiert wird, wobei der Unterdruck aufrechterhalten wird; und
das Fluor in der zweiten Kammer (4) entfemt wird.

6. Verfahren nach Anspruch 4,
wobei der leitfähige Film einen Titanfilm (14), der auf dem Isolierfilm (13) und dem Teil des Halbleitersubstrats (11) ausgebildet ist, und einen Titannitrid-Film (15), der auf dem Titanfilm ausgebildet ist, aufweist.

7. Verfahren nach Anspruch 1 oder 5,
wobei die Zeitperiode mehr als vier Stunden ist.

## Revendications

1. Procédé de fabrication d'un dispositif semi-conducteur comprenant les étapes consistant à :
former par-dessus un substrat semi-conducteur (11) une couche conductrice (14, 15) contenant du titane ;
former un film en tungstène (16) sur ladite couche conductrice ;
graver ledit film en tungstène en utilisant un gaz réactif contenant du fluor jusqu'à ce que la surface de ladite couche conductrice soit exposée ;
éliminer le fluor de la surface de ladite couche conductrice ;
**caractérisé en ce que** ledit substrat semi-conducteur (11) est maintenu dans une atmosphère de vide durant la période de temps allant de l'achèvement de l'étape consistant à graver jusqu'au début de l'étape consistant à éliminer le fluor, et **en ce que** ledit fluor est éliminé en chauffant ledit substrat semi-conducteur tout en soufflant un gaz inerte sur la surface dudit substrat semi-conducteur.

2. Procédé selon la revendication 1, dans lequel ledit substrat semi-conducteur est chauffé à une température de 220° C ou plus.

3. Procédé selon la revendication 1, dans lequel ladite étape consistant à éliminer le fluor est accomplie dans un gaz de plasma d'hydrogène.

4. Procédé selon la revendication 2 ou 3, comprenant en outre les étapes consistant à :
former un film isolant (13) sur ledit substrat semi-conducteur avant que ladite couche conductrice (14, 15) ne soit formée ; et
former sélectivement un trou (13a, 13b) dans ledit film isolant pour exposer une partie dudit substrat semi-conducteur ;
dans lequel ledit film conducteur (14, 15) est formé de manière à se trouver en contact avec ledit film isolant (13) et ladite partie dudit substrat semi-conducteur (11).

5. Procédé selon l'une quelconque des revendications 1 à 4, dans lequel ledit procédé est exécuté dans un appareil pourvu d'une première chambre (3), d'une seconde chambre (4) et d'une chambre à vide (2) couplée aux dites première et seconde chambres ;
ledit film en tungstène (16) est gravé dans ladite première chambre (3) ;
ledit substrat semi-conducteur est transféré à partir de ladite première chambre (3) dans la chambre à vide (2) tout en maintenant le vide après que ledit film en tungstène a été gravé ;
ledit substrat semi-conducteur est maintenu dans une atmosphère de vide dans ladite chambre à vide (2) durant une période de temps ;
ledit substrat semi-conducteur est transféré de ladite chambre à vide (2) dans ladite seconde chambre (4) tout en maintenant le vide ; et
ledit fluor est éliminé dans ladite seconde chambre (4).

6. Procédé selon la revendication 4, dans lequel ledit film conducteur comprend un film en titane (14) formé sur ledit film isolant (13) et ladite partie dudit substrat semi-conducteur (11) et un film en nitrure de titane (15) formé sur ledit film en titane.

7. Procédé selon la revendication 1 ou 5, dans lequel ladite période de temps est supérieure à 4 heures.
